(19) Europäisches Patentamt
European Patent Office
Office européen des brevets

(11) **EP 1 873 124 A2**

(12) **DEMANDE DE BREVET EUROPEEN**

(43) Date de publication:
**02.01.2008 Bulletin 2008/01**

(51) Int Cl.:
*C03B 19/06* (2006.01)    *B28B 1/26* (2006.01)
*C30B 15/10* (2006.01)    *C30B 35/00* (2006.01)

(21) Numéro de dépôt: **07117591.3**

(22) Date de dépôt: **04.08.2004**

(84) Etats contractants désignés:
**AT BE BG CH CY CZ DE DK EE ES FI FR GB GR HU IE IT LI LU MC NL PL PT RO SE SI SK TR**

(30) Priorité: **07.08.2003 FR 0309732**

(62) Numéro(s) de document de la (des) demande(s) initiale(s) en application de l'article 76 CBE:
**04786258.6 / 1 663 881**

(71) Demandeur: **Saint-Gobain Centre de Recherches et d'Etudes Européen**
**92400 Courbevoie (FR)**

(72) Inventeurs:
• **Linnot, Cyril**
  **13290 Aix-en-Provence (FR)**
• **Poullain, Bernard**
  **75014 Paris (FR)**

(74) Mandataire: **Sartorius, Jérome**
  **Cabinet Nony et Associés**
  **3, rue de Penthièvre**
  **75008 Paris (FR)**

Remarques:
Cette demande a été déposée le 01 - 10 - 2007 comme demande divisionnaire de la demande mentionnée sous le code INID 62.

(54) **Procédé de fabrication d'une pièce en silice amorphe frittée**

(57) Procédé de fabrication d'une pièce en silice frittée comportant les étapes suivantes :

a) coulage d'une barbotine à base de poudre de silice amorphe et d'un liquide, dans un moule de fabrication d'une préforme, le moule comportant des parties intérieure et extérieure aptes à délimiter une paroi de la préforme, une seule des parties intérieure et extérieure, dite « partie perméable », étant perméable au liquide, au moins dans une zone délimitant une portion utile de ladite paroi,

b) évacuation, au moins partielle, du liquide, pour obtenir une préforme, le liquide étant évacué à travers la seule partie perméable dans au moins la zone délimitant une portion utile de la paroi,

c) démoulage de la préforme pour obtenir une pièce crue,

d) séchage complémentaire de la pièce crue,

e) frittage de ladite pièce crue.

Ce procédé est remarquable en ce que la granulométrie de la poudre suit la loi de Füller-Bolomey, la poudre présentant un indice de compacité inférieur à 500.

Fig. 1

## Description

L'invention concerne un procédé de fabrication d'une pièce en silice amorphe frittée, ainsi qu'un moule et une barbotine mis en oeuvre dans ce procédé.

A titre préliminaire, on donnera les définitions suivantes.

On désigne par « barbotine » une substance formée par une suspension de particules dans un liquide, généralement de l'eau avec ou sans additifs tels que dispersants, défloculants, polymères, etc.

En particulier une « barbotine de silice » est une barbotine dont les particules sont constituées essentiellement de silice. Sauf indication contraire, le mot « barbotine » est employé dans ce document pour désigner une barbotine de silice.

On appelle « pièce crue » la pièce obtenue après démoulage et avant frittage, qui a subi un séchage au moins partiel suffisant pour assurer l'intégrité de la pièce et le maintien de la géométrie lors de sa manutention après démoulage.

On désigne par « préforme » la pièce crue avant son démoulage.

La pièce en silice frittée peut être en particulier un creuset utilisé pour la croissance cristalline de silicium, en particulier de silicium poly-cristallin utilisé par exemple pour l'industrie des semi-conducteurs ou pour la production de tranches, en anglais « wafers », destinées aux cellules photovoltaïques qui constituent les panneaux solaires.

Pour ces applications, la silice utilisée ou l'une des silices entrant dans le mélange de poudres qui constituent la partie sèche de la barbotine doit être particulièrement pure (en particulier l'une des silices peut être synthétique), et le procédé de mise en oeuvre ne doit pas introduire d'impuretés au-delà des spécifications imposées par les clients. En particulier la surface intérieure du creuset, en contact avec le silicium, doit rester pure pendant le cycle de cristallisation.

Plusieurs types de procédés de fabrication sont connus pour réaliser des creusets ou autres pièces en silice.

On connaît d'abord un procédé de fusion de sable de quartz par un arc électrique tel que décrit, par exemple, dans FR-A-2 726 820. La matière première est introduite dans un moule creux en rotation et la force centrifuge permet de répartir et maintenir le sable de quartz sur les parois de ce moule. Le chauffage par un arc électrique permet ensuite de réaliser la fusion du sable de quartz en silice amorphe et ainsi de fabriquer le creuset.

Avec ce type de procédé, la forme du creuset est nécessairement de révolution. En particulier, il est impossible de produire un creuset de forme cubique ou présentant une paroi d'épaisseur constante.

On connaît également des procédés de fabrication par voie sol-gel ou par dépôt électrophorétique comme, par exemple, celui décrit dans US 2002/152768. Cependant, avec ces procédés, la teneur en eau des préformes, est très importante. Il en résulte de forts retraits dimensionnels, typiquement supérieurs à 5 %, lors du séchage. Les creusets doivent donc rester de taille réduite, typiquement inférieure à 300 - 400 mm.

De plus, le coût de tels creusets est généralement élevé, notamment à cause du coût des précurseurs, du nombre et de la longueur des étapes requises.

On connaît encore des procédés de fabrication par coulage d'une barbotine dans un moule en plâtre, séchage et frittage. Pendant la prise de la barbotine, le plâtre absorbe partiellement l'eau de la barbotine, ne laissant dans le moule que de la matière sèche et de l'eau de constitution de la pièce crue.

La pièce crue obtenue avec ces procédés est très fragile et difficile à manipuler. Il est donc difficile de produire des pièces ayant à la fois des grandes dimensions et des parois minces de section constante ou qui présentent des angles de dépouille très faibles.

En effet de telles pièces sont très difficiles démouler sans dommage puis à manipuler par la suite. Les barbotines de silice n'ont pas le caractère plastique des barbotines contenant, par exemple, de l'argile. Les pièces crues sont donc extrêmement sensibles à toute contrainte mécanique. Les contraintes créent des défauts tels que des fissures, des déformations, des marques...

Ces contraintes peuvent, par exemple, être induites par le séchage dans ou hors du moule. Elles peuvent aussi être exercées par le moule, l'un de ses constituants, un accessoire ou un opérateur lors des opérations de fabrication, en particulier lors du démoulage. Ces contraintes peuvent être induites dans la matière de la pièce crue ou exercée directement sur cette pièce, par exemple par frottement lors du démoulage ou autre opération de fabrication, ou par le moindre choc.

De plus, le plâtre pollue la pièce de ses éléments constitutifs, en particulier alcalins et alcalino-terreux tels que le calcium et le sodium.

Parmi les procédés de fabrication par coulage d'une barbotine, séchage et frittage, US 5,360,773 propose d'utiliser, pour fabriquer la barbotine, une poudre à base de silice présentant une répartition granulométrique spécifique et une surface spécifique élevée pour favoriser la mise en forme et le frittage.

Mais la préparation des poudres décrite dans ce document nécessite plusieurs étapes de procédé coûteuses. En outre, les particules de silice étant très fortement hydrophiles, plus leur surface spécifique augmente, plus la teneur en eau de la barbotine doit être élevée pour permettre son coulage dans le moule. Le choix de particules présentant une surface spécifique élevée conduit donc à un retrait dimensionnel élevé lors du séchage qui induit des risques de déformation et de création de contraintes résiduelles. De plus, le retrait dimensionnel important rend difficile l'obtention de tolérances dimensionnelles serrées.

Des approches récentes, telles que celle décrite dans WO 0117902, tentent de résoudre ce problème. Selon cette demande de brevet, la répartition granulométrique des particules de silice doit être bimodale et la proportion en liquide, en poids dans la barbotine, peut être diminuée et ramenée à une valeur inférieure à 20%.

La diminution de la quantité de liquide (eau, le plus souvent) permet effectivement de diminuer le retrait dimensionnel mais ne l'annule pas complètement.

Ce retrait est également lié à la compacité de la pièce crue. Une distribution bimodale ne permet pas d'atteindre une compacité optimale à cru. Ainsi les densités à cru obtenues selon le brevet WO 0117902 sont typiquement de l'ordre de 1,6 et une température de plus de 1350°C est requise pour obtenir une densité supérieure à 1,8 selon les résultats présentés dans WO 0117902.

Le retrait de la matière crée des contraintes mécaniques dans la préforme en cours de formation lors de la prise de la barbotine dans le moule, puis de la pièce crue lors du séchage. Le risque que la pièce casse est donc élevé, en particulier si celle-ci est de taille importante.

Une distribution bimodale ne sera donc préconisée que dans le cas de pièces de taille réduite et/ou ayant une paroi de faible épaisseur et/ou de faible densité.

Il existe donc un besoin pour un procédé de fabrication d'une pièce en silice frittée qui soit simple, permette de réaliser des pièces de grandes dimensions, d'une forme quelconque, éventuellement comportant des parois d'épaisseur faible, à faible porosité, d'une densité à cru élevée typiquement supérieure à 1,9, sensiblement sans retrait pendant le séchage, et qui permette de préserver la pureté des poudres employées dans la barbotine.

Le but de la présente invention est de satisfaire ce besoin.

Selon l'invention, on atteint ce but au moyen d'un procédé de fabrication d'une pièce en silice frittée comportant les étapes suivantes :

    a) coulage d'une barbotine à base de poudre de silice amorphe et d'un liquide, entre des parties intérieure (14) et extérieure (12) d'un moule (10) de manière à délimiter une paroi (38) de ladite pièce (40),
    b) évacuation, au moins partielle, dudit liquide, pour obtenir une préforme,
    c) démoulage de ladite préforme pour obtenir une pièce crue,
    d) séchage complémentaire de ladite pièce crue,
    e) frittage de ladite pièce crue.

Ce procédé de fabrication est remarquable en ce que, à l'étape b), dans au moins une zone délimitant une portion utile de ladite paroi, on évacue ledit liquide à travers une seule desdites parties intérieure et extérieure dudit moule, dite « partie perméable », l'autre partie étant appelée « partie imperméable ».

Comme on le verra plus en détail dans la suite de la description, la pièce frittée ainsi fabriquée présente avantageusement une très forte compacité (densité supérieure ou égale à 1,9 g/cm$^3$). De plus, la partie imperméable permet d'éviter toute pollution chimique de la silice par contact.

Avantageusement encore, les formes de la préforme et de la pièce frittée peuvent être quelconques, pourvu que le démoulage reste possible. En particulier, la préforme peut être cubique, cylindrique, et plus généralement avoir toute forme de conteneur ou de creuset.

Avantageusement encore, le profil en coupe transversale d'une paroi du moule révèle une porosité très homogène et, du côté en contact avec la partie imperméable du moule, un état de surface remarquablement similaire à celui de la face imperméable du moule.

Avantageusement encore, le procédé selon l'invention permet de fabriquer des pièces d'épaisseur réduite (typiquement moins de 20 mm) et très régulière, de grandes dimensions (typiquement de plus de 500 mm), présentant des angles de dépouille très faibles (typiquement de moins de 1 °), de bonne pureté, à faible coût et sans nécessiter de traitement ultérieur au frittage.

De préférence, le procédé selon l'invention comporte encore les caractéristiques suivantes :

-    Préalablement à l'étape e), on dispose un matériau de revêtement, de préférence un précurseur du nitrure de silicium ($Si_3N_4$), à la surface de ladite pièce crue.

-    Pendant l'étape b), on poursuit l'alimentation en barbotine dans ledit moule de manière à compenser l'évacuation dudit liquide. Le procédé selon l'invention permet une évacuation lente du liquide, favorisant ainsi avantageusement la compensation de cette évacuation par de la barbotine complémentaire.

-    Pendant l'étape b), on peut également maintenir une dépression avant coulage de la barbotine et/ou indépendamment dans ledit moule de manière à favoriser l'élimination de bulles dans ladite barbotine. Avantageusement, la porosité de la préforme en est diminuée. De même, un vide partiel peut être appliqué à la barbotine juste avant coulage pour éliminer des bulles.

L'invention concerne également une pièce crue fabriquée selon les étapes a) à c) du procédé selon l'invention. Cette pièce crue est remarquable en ce qu'elle présente une résistance en flexion trois points, mesurée selon le test décrit dans les exemples, comprise entre 2 et 10 MPa.

L'invention concerne aussi une pièce en silice frittée fabriquée selon le procédé de l'invention, en particulier un creuset, remarquable en ce qu'elle présente une résistance en flexion trois points comprise entre 16 et 30 MPa et, de préférence, une densité comprise entre 1,6 et 2,2 g/cm$^3$.

L'invention concerne encore l'utilisation de ce creuset en poudre de silice amorphe donnant une pureté supérieure à 99,5% de silice pour la fabrication de lingots de silicium poly-cristallin.

L'invention concerne également un moule de fabrication d'une préforme à base de silice destinée à être frittée, prévu pour recevoir une barbotine à base de particules de silice amorphe et d'un liquide, comportant des parties intérieure et extérieure aptes à délimiter une paroi de ladite préforme. Ce moule est remarquable en ce que, au moins dans une zone délimitant une portion utile de ladite paroi, une seule desdites parties intérieure et extérieure est perméable audit liquide.

Ce moule est de préférence mis en oeuvre dans le procédé selon l'invention.

Ce moule présente de préférence les autres caractéristiques suivantes :

- Dans ladite zone, l'écartement entre lesdites parties intérieure et extérieure est sensiblement constant, de préférence inférieur à 10 cm, de préférence encore inférieur à 5 cm.

- Ladite partie perméable est en un matériau absorbant ledit liquide, de préférence en plâtre ou un matériau absorbant ledit liquide de manière similaire au plâtre.

- Dans au moins une zone délimitant une portion utile de ladite paroi, l'une au moins desdites parties intérieure et extérieure est déformable. Avantageusement, cette partie déformable permet de minimiser les contraintes résiduelles et les déformations dans la préforme; ainsi qu'exercées sur la préforme lors de sa formation en adaptant sa forme sous l'effet des contraintes exercées par la matière de la préforme lors de l'étape b). La partie déformable présente cependant une rigidité intrinsèque suffisante pour pouvoir délimiter une paroi de la préforme lorsque la barbotine est introduite dans le moule. A la différence du moule décrit dans DE 101 30 186, aucun recours à une pression extérieure n'est nécessaire pour conférer cette rigidité au moule. Cette partie déformable peut ensuite être pelée de la préforme, comme décrit plus loin, lors de l'étape de démoulage c) et éviter ainsi d'exercer chocs ou frottements sur la préforme qui est alors facilement endommagée.

- Ladite partie imperméable audit liquide, faisant face à ladite partie perméable, comporte une chemise déformable sous l'effet d'une modification des dimensions de ladite préforme pendant sa fabrication. Avantageusement, la souplesse de la chemise évite des casses pendant la fabrication des préformes, la chemise restant adjacente à la barbotine lors du retrait résultant de la prise.

- Ladite chemise est conformée de manière à pouvoir être retirée ou « pelée » vers l'intérieur de ladite préforme en évitant tout contact avec ladite préforme. Avantageusement, la souplesse de la chemise permet ainsi d'éviter les frottements et autres contraintes mécaniques lors de l'opération de démoulage.

- De préférence encore, ladite chemise est suffisamment déformable pour, lors du démoulage de ladite préforme, autoriser un passage en force d'une protubérance de ladite préforme d'une hauteur inférieure ou égale à 1,1 fois l'épaisseur de ladite chemise. Avantageusement, une préforme en forme de creuset peut ainsi, par exemple, porter un marquage ou un motif en relief à sa surface en contact avec la chemise, ou être évasée vers le fond du creuset.

- Ladite chemise est en un matériau inerte, en particulier chimiquement, vis-à-vis de ladite barbotine. Avantageusement, cette caractéristique évite la diffusion de matière depuis la partie imperméable vers la préforme. La contamination de la préforme par des espèces physico chimiques indésirables, telles que par exemple des alcalins et des alcalino-terreux, est ainsi évitée. De plus, cette caractéristique évite toute modification chimique de la préforme résultant de son contact avec la chemise.

- Ladite chemise, de préférence en silicone ou en un matériau alvéolaire, n'adhère pas ou peut être décollée de ladite préforme par déformation de ladite chemise lors du démoulage, en particulier par injection d'air entre ladite chemise et ladite préforme. Aucun agent démoulant n'est donc plus nécessaire entre la chemise et la préforme. Comme on le verra plus en détail dans la suite de la description, une couche de matériau de revêtement peut ainsi être appliquée sur la préforme après son démoulage.

- Ladite chemise comporte des trous d'injection d'air. Avantageusement, l'air injecté facilite le démoulage de la préforme en favorisant le décollement de la chemise et son glissement sur la préforme.

- Ladite partie imperméable audit liquide comporte un support de ladite chemise. De préférence, lors du démoulage de la préforme, on retire ledit support sans entraîner ladite chemise, évitant ainsi tout frottement sur la préforme, puis on procède au décollement de ladite chemise et au démoulage de la préforme. Avantageusement, la casse ou l'endommagement de la préforme sont ainsi évités.

L'invention concerne encore une barbotine comportant une poudre contenant plus de 99,5 % de silice amorphe, mélangée à un liquide, de préférence de l'eau avec ou sans additif, remarquable en ce qu'elle comporte plus de 85 % de matières sèches et présente une viscosité comprise entre 1 et 30 Poises au moment d'être coulée dans un moule.

De préférence, la poudre de silice ou chacune des poudres qui peut éventuellement constituer la poudre finale par mélange, a une surface spécifique comprise entre 0,01 et 20 m$^2$/g.

De préférence encore, la distribution granulométrique finale de la poudre, éventuellement obtenue par mélange, puis incorporée au liquide pour fabriquer la barbotine, suit au plus prés la distribution théorique de Füller-Bolomey.

Avantageusement, une telle barbotine permet d'obtenir une forte compacité de la préforme, typiquement de densité supérieure à 1,9, notamment lorsqu'elle est mise en oeuvre avec le procédé selon l'invention.

L'invention concerne encore l'utilisation d'une barbotine selon l'invention dans un procédé de fabrication d'une pièce crue destinée à être frittée, ledit procédé comportant une étape de coulage sous pression.

D'autres caractéristiques et avantages de la présente invention apparaîtront à la lecture de la description qui va suivre et à l'examen du dessin annexé dans lequel :

- la figure 1 représente, en coupe transversale, un moule selon l'invention,

- la figure 2 représente un creuset fabriqué au moyen du moule représenté sur la figure 1,

- les figures 3 et 4 représentent des photographies de coupes de pièces crues coulées avec des barbotines selon la technique antérieure et selon l'invention, respectivement,

- la figure 5 représente le profil transversal de concentration en calcium (Ca) de la paroi du creuset de la figure 2,

- la figure 6 représente une photographie prise au MEB d'une coupe transversale de la paroi d'une pièce frittée selon la technique antérieure.

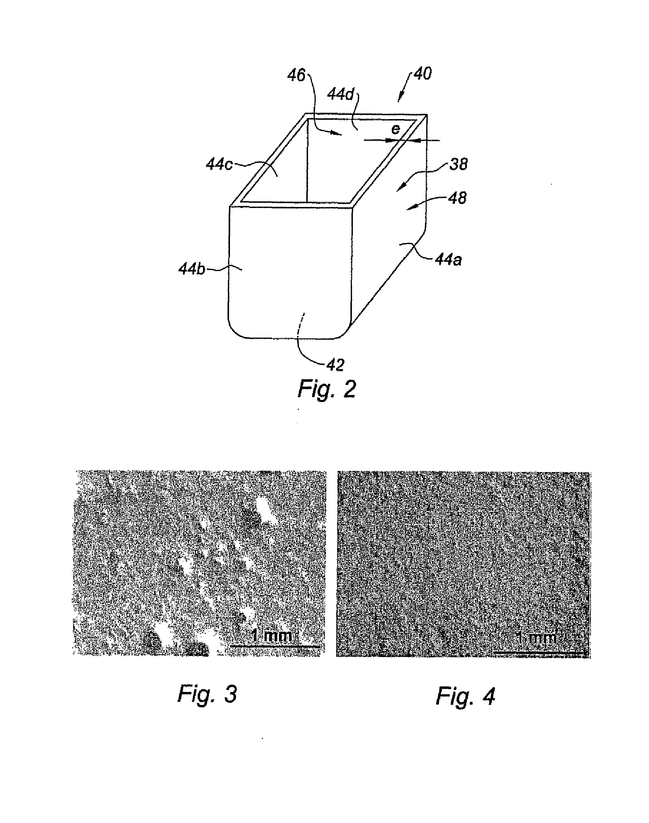

La pièce frittée selon l'invention a une forme et des dimensions sensiblement identiques à celles de la pièce crue utilisée pour sa fabrication. Les références utilisées sur la figure 2 pour désigner des parties d'un creuset selon l'invention sont donc également utilisées pour désigner les parties correspondantes de la pièce crue et de la préforme dont ce creuset est issu.

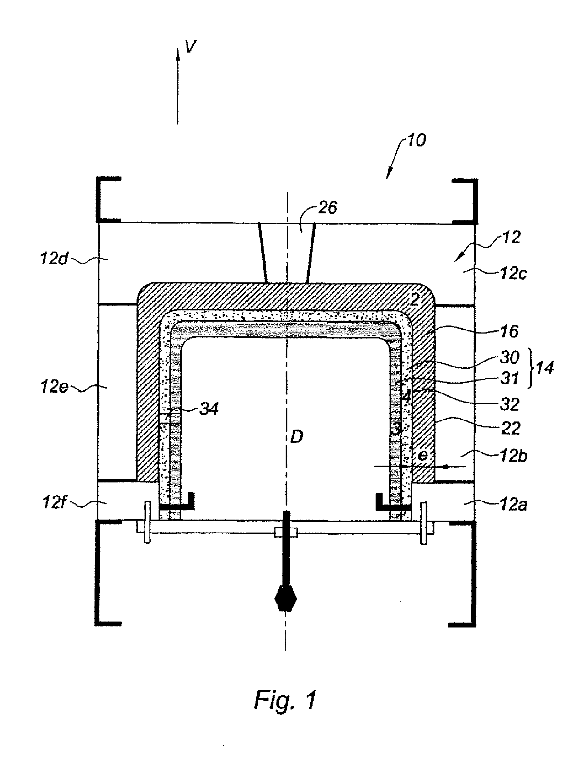

La figure 1 représente un moule selon l'invention, utilisé pour réaliser les exemples ci-dessous.

Le moule 10 comporte une partie extérieure 12, ou « partie femelle», et une partie intérieure 14, ou « partie mâle », ou « noyau interne ». La partie intérieure 14 est insérée dans la partie extérieure 12, de manière à définir un volume de moule 16 destiné à recevoir de la barbotine à base de silice amorphe. Le volume 16 du moule 10 représenté sur la figure 1 a la forme d'un creuset renversé. La flèche V définit l'axe vertical et pointe vers le haut.

La partie extérieure 12 comporte une face intérieure 22 poreuse, par exemple en plâtre, par laquelle le liquide peut être évacué du volume 16. Elle est percée d'une ouverture supérieure 26 par laquelle la barbotine peut être introduite, par gravité, dans le volume 16. De préférence, la partie extérieure 12 comporte un assemblage de blocs 12a-12f pouvant être désassemblés de manière à pouvoir libérer la préforme en exerçant un minimum de contraintes.

La partie intérieure 14 comporte une chemise 30 et un support de chemise 31.

La chemise 30, par exemple en silicone ou en un matériau cellulaire de type mousse, comporte une face extérieure 32 destinée à être en contact avec la barbotine et imperméable au liquide. De préférence, la chemise 30 est souple et n'adhère pas ou peu à la préforme.

Par « souple », on entend « présentant une souplesse suffisante pour accompagner l'évolution dimensionnelle de la pièce en cours de formation à l'intérieur du moule 10 ». On adapte cette souplesse par le choix de la nature du matériau et de l'épaisseur de la chemise. La tenue pour garantir la forme souhaitée est assurée par le support 31.

Avantageusement, la souplesse de la chemise 30 protège la pièce en cours de formation et la préforme des chocs extérieurs. En particulier, la chemise 30 peut être laissée provisoirement sur la préforme après écartement du support 31 afin de la protéger pendant sa manipulation. De préférence, la souplesse de la chemise 30 est suffisante pour qu'elle puisse se déformer, sans casser ou endommager la préforme, lors de son passage en force d'une surépaisseur de la préforme. La déformation peut par exemple résulter du passage d'une protubérance de la préforme orientée perpendiculairement à la direction de démoulage D. La protubérance peut par exemple être une lettre en relief ménagée sur la surface intérieure de la préforme en contact avec la face extérieure 32 de la chemise 30 pendant le moulage.

De préférence encore, la souplesse de la chemise 30 est suffisante pour qu'elle puisse être « pelée », c'est-à-dire être enlevée de la préforme petit à petit, de préférence en se repliant sur elle-même. Avantageusement, l'enlèvement de la partie intérieure 14 peut donc se faire progressivement par pelage de la chemise 30, les parties de la chemise 30 mises hors contact de la préforme étant repliées vers l'intérieur de la préforme. La préforme peut ainsi être démoulée sans frottements avec la chemise 30, ce qui réduit les risques de casser la préforme.

L'adhésivité de la chemise 30 sur la préforme est de préférence suffisamment faible pour que la chemise 30 puisse être enlevée de la préforme, sans se déchirer, par une traction tendant à l'écarter de la préforme. En particulier, des matériaux n'ayant aucune affinité physico chimique avec les constituants de la barbotine sont privilégiés. De préférence, l'adhésivité est suffisamment faible pour qu'une injection d'air sous une faible pression, typiquement comprise entre 1 et 5 atmosphères entre la face extérieure 32 et la préforme suffise à décoller la chemise 30 après écartement du support 31. De préférence, des trous d'injection d'air 34 sont ménagés dans la chemise 30 à cet effet.

La position de ces trous est donnée par exemple sur la figure 1. D'autres emplacements peuvent être préférés et adaptés à la géométrie de la pièce.

De préférence encore, la chemise 30 est inerte vis-à-vis de la barbotine, c'est-à-dire qu'elle ne réagit pas chimiquement avec la barbotine et qu'elle ne diffuse pas dans la barbotine les éléments chimiques qui la constituent.

Le support de chemise 31 est conçu pour soutenir la chemise 30 et éviter son affaissement sous l'effet de la barbotine avant que celle-ci n'ait effectué sa prise. De préférence, le support 31 est en matériau rigide, par exemple du métal. De préférence encore, la chemise 30 n'est pas collée sur le support 31 afin que ce dernier puisse être retiré indépendamment de la chemise 30.

Le volume de moule 16 est délimité par la face intérieure 22 poreuse et par la face extérieure 32 imperméable. L'écartement entre les faces intérieures 22 et extérieure 32 est de préférence inférieur à 10 cm, de préférence encore inférieur à 5 cm, en particulier inférieur à 25 mm.

Cet écartement définit l'épaisseur « e » d'une paroi 38 d'un creuset 40, tel que représenté sur la figure 2. La paroi 38, de forme complémentaire à celle du volume 16, comporte un fond 42 et quatre parois latérales 44a-44d. La paroi 38 porte une surface intérieure 46 destinée à être en contact avec le silicium poly-cristallin à fabriquer, dite « surface de contact » et une surface extérieure 48, sensiblement parallèle à la surface intérieure 46.

Selon l'invention, dans les zones du moule 10 dans lesquelles sont formées les portions utiles de la paroi 38, c'est-à-dire les portions de la paroi 38 portant une surface de contact, une seule des parties extérieure et intérieure du moule 10 est perméable au liquide.

De préférence, la barbotine selon l'invention, introduite dans le volume de moule 16, comporte une poudre contenant plus de 99,5 % de silice amorphe, mélangée à un liquide, de préférence de l'eau. Selon l'invention, la barbotine comporte plus de 85 % de matières sèches et présente une viscosité comprise entre 1 et 30 Poises au moment d'être coulée dans un moule.

Par « poudre », on entend, dans la présente description, une poudre ou un mélange de poudres.

La viscosité doit permettre à un litre de barbotine de s'écouler sous son propre poids à travers un orifice calibré de 23 mm en moins d'une minute et en plus de 5 secondes. Une telle viscosité permet avantageusement aux bulles d'air emprisonnées lors du remplissage du moule d'être évacuées naturellement. La préforme présente ainsi une compacité forte et, avantageusement, la paroi 38 du creuset 40 est ainsi exempte de bulles résiduelles.

La très faible viscosité de la barbotine selon l'invention au moment du coulage permet de réaliser des pièces d'épaisseur réduite et constante. Il est ainsi possible de couler des articles ayant des dimensions supérieures à 700 mm, avec des parois verticales d'épaisseur inférieure à 20, voire 10 mm. La viscosité mesurée varie de 1 à 30 Poises.

Cette valeur de viscosité est mesurée en ambiance climatisée à 20 °C, par un Rhéomètre Rhéolab Physica LM/MC dans une cuve de diamètre 44 mm et hauteur 157 mm avec une pale à deux ailettes de largeur 25mm, hauteur 80 mm et épaisseur 2mm (mobile de type "Z2 DIN") immergée entièrement dans la barbotine à caractériser.

La mesure est réalisée à l'aide du logiciel du constructeur en imposant la vitesse de rotation du mobile et en mesurant la contrainte exercée lors d'un cycle de 180 secondes. Ce cycle comprend une phase de montée de la vitesse de cisaillement (shear rate) de 0 à 150 $s^{-1}$ en soixante secondes, un palier de soixante secondes à 150 $s^{-1}$, puis une descente de la vitesse de cisaillement de 150 à 0 $s^{-1}$.

La viscosité est mesurée à l'issue du palier lorsque la vitesse de rotation du mobile est constante. La viscosité est alors calculée par la formule : $\eta = \tau/D$, où $\eta$ est la viscosité, $\tau$ est la contrainte de cisaillement mesurée et $D$ est la vitesse de cisaillement imposée.

La viscosité souhaitée de la barbotine est obtenue par dosage initial des composants de la barbotine, contrôle juste avant coulage et ajustement de la teneur en eau si nécessaire.

Avantageusement, la préparation de la barbotine selon l'invention permet de minimiser le retrait de la pièce lors des opérations de séchage et de frittage. On obtient ainsi un excellent contrôle dimensionnel.

De préférence, ladite poudre de silice amorphe ou chacune de ses poudres constituantes a une surface spécifique comprise entre 0,01 et 20 m$^2$/g.

De préférence, la poudre à base de silice amorphe présente une granulométrie qui suit la loi de Füller-Bolomey.

On rappelle ici que la théorie de Füller-Bolomey permet de simuler une répartition idéale de grains en connaissant le diamètre des plus gros grains de la poudre ou du mélange de poudres ($d_{max}$) et celui des plus petits ($d_{min}$).

Le pourcentage cumulé de grains de taille inférieure à un diamètre d ($y_d$) est alors calculable selon la formule :

$$y_d = ad^{\frac{1}{5}} + b \quad \text{où} \quad a = \frac{100}{d_{max}^{\frac{1}{5}} - d_{min}^{\frac{1}{5}}} \quad \text{et} \quad b = -ad_{min}^{\frac{1}{5}}$$

Si $y_{d\ exp}$ est le pourcentage massique cumulé du grains du mélange expérimental de diamètre inférieur à d et $y_{d\ \text{Füller-Bolomey}}$, le pourcentage massique cumulé du grains du mélange théorique de diamètre inférieur à d, on peut alors définir un indice de compacité (I) est comme suit :

$$I = \sum_{d_{min}}^{d_{max}} \left( y_{d_{exp}} - y_{d_{Füller-Bolomey}} \right)^2$$

Les points de mesure sont répartis de 0,1 en 0,1 $\mu$m si d<1 $\mu$m, de 1 en 1 $\mu$m si d<10$\mu$m, de 10 en 10 $\mu$m si d<100$\mu$m et de 100 en 100 $\mu$m si d<1000$\mu$m.

L'indice I recherché est donc le plus faible possible. Dans ce cas, la courbe expérimentale est la plus proche possible du modèle de Füller-Bolomey. Avantageusement, cet indice est inférieur à 500, avantageusement encore, cet indice est inférieur à 100.

Bien entendu, d'autres modèles de distribution théorique optimale peuvent être employés pour obtenir des poudres aboutissant à une compacité satisfaisante qui entre dans la zone de répartition granulométrique définie ci-dessus.

L'une ou plusieurs des poudres de silice du mélange peuvent être de la silice synthétique, c'est à dire fabriquée par synthèse à partir de précurseurs chimiques organiques ou minéraux et non obtenues par fusion de minéraux raffinés ou non. Avantageusement, ce type de silice présente un taux d'impuretés très faible, classiquement inférieur à une partie par million, et typiquement de quelques ppb (partie par billion).

La barbotine peut être fabriquée selon des techniques connues de l'homme du métier par malaxage des poudres dosées et de la quantité souhaitée de liquide.

Pour fabriquer une pièce en silice frittée selon l'invention, on procède de la manière suivante. Un agent démoulant est appliqué sur la face intérieure 22 de la partie perméable 12 du moule 10.

Après avoir préparé une barbotine selon l'invention, on introduit celle-ci dans le moule 10, par gravité, par l'ouverture supérieure 26. Le récipient contenant la barbotine et le volume 16 peuvent éventuellement être mis, temporairement et indépendamment, sous dépression de préférence de plus de 0,5 atm pour éliminer au mieux les bulles résiduelles de la barbotine.

Après remplissage du volume 16, la face intérieure 22 poreuse du moule 10 absorbe, au moins en partie, le liquide de la barbotine. Le remplissage complet du volume 16 et l'évacuation peuvent être favorisés par une mise sous pression hydrostatique de l'intérieur du moule 10, grâce à l'utilisation d'une colonne d'alimentation de hauteur adaptée à la géométrie de la pièce.

Quand la poudre de silice suit de près la loi de Füller-Bolomey, et que ladite poudre ne comporte que des particules dont la taille est comprise entre 0,2 $\mu$m et 200 $\mu$m, la barbotine est particulièrement adaptée pour une mise en oeuvre au moyen d'un procédé comportant une étape de moulage sous pression.

A mesure que le liquide est évacué, les particules de silice amorphe s'immobilisent les unes par rapport aux autres. Cette immobilisation est appelée prise de la préforme. La porosité résiduelle entre les particules immobilisées autorise cependant la traversée par le liquide, et son absorption par l'extérieur du moule 10.

Cette prise s'effectue progressivement depuis la face intérieure 22 poreuse jusqu'à la face extérieure 32 imperméable au liquide.

De la barbotine complémentaire est introduite dans le moule 10 à mesure que le liquide est absorbé. Avantageusement, une partie du volume laissé vacant par le liquide est ainsi remplie par des particules de silice de la barbotine complémentaire.

Après cette étape, le moule 10 contient la préforme. On cesse alors toute alimentation en barbotine complémentaire et on procède au démoulage de la préforme.

A cet effet on retire le support 31 qui n'adhère pas à la chemise 30. La préforme maintient son intégrité géométrique, le liquide ayant été évacué. La chemise 30 est alors enlevée de la préforme par exemple par injection d'air à travers les trous 34. Ce résultat peut également provenir d'une traction exercée sur la chemise 30, ou d'un repli contrôlé de la chemise sur elle-même. Le mode exact d'enlèvement de la chemise s'adapte selon la géométrie de la pièce.

Les blocs 12a-12f sont désolidarisés et écartés de la préforme. La présence de l'agent démoulant sur la face intérieure 22 facilite le démoulage. La surface extérieure 48 du creuset n'étant pas « de contact », c'est à dire pas au contact du contenu du creuset lors de son utilisation, sa contamination par des éléments de la partie perméable 12 ou par de l'agent démoulant est de moindre importance.

Après démoulage, la préforme est séchée puis frittée selon des procédés classiques. Avantageusement, la préforme présente les caractéristiques suivantes :

- Résistance en flexion trois points, mesurée selon le test décrit dans les exemples comprise entre 2 et 10 MPa ;

- Faible présence de bulles ou de porosité de taille supérieure à 20 $\mu$m, comme cela est visible sur la figure 4. Cette figure 4 est à comparer avec la figure 3 représentant la coupe d'un échantillon coulé avec une barbotine ayant une viscosité supérieure à 30 P et n'ayant pas permis l'évacuation des bulles qui y étaient prisonnières.

La pièce frittée présente une résistance en flexion trois points comprise entre 16 et 30 MPa et une densité comprise entre 1,6 et 2,2 g/cm$^3$.

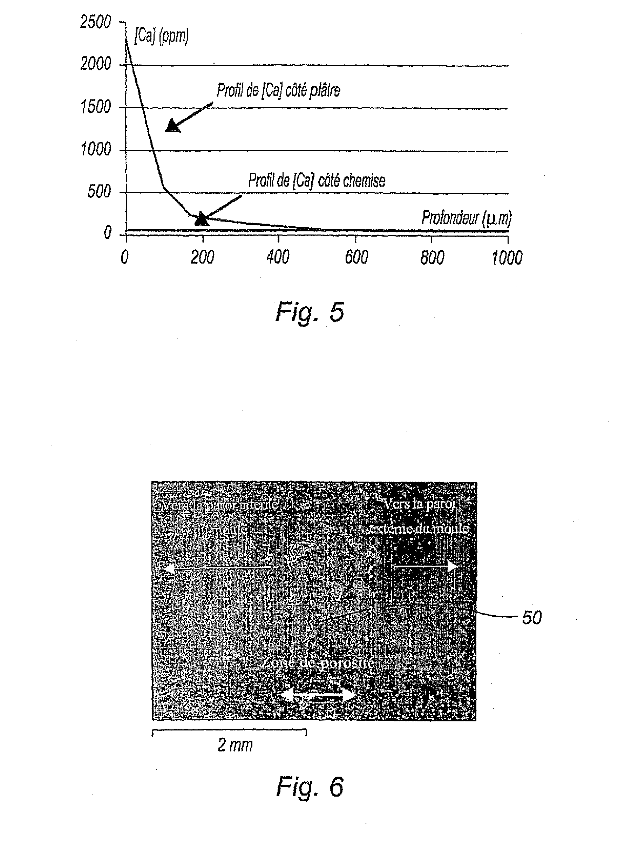

Sans être liée par une quelconque théorie, la Demanderesse explique en partie les performances mécaniques des pièces frittées selon l'invention par l'absence d'un « front de divergence » issu d'une ligne de séparation des eaux 50 au sein de la paroi 38 (voir figure 6).

Avec un moule classique à deux parties perméables en plâtre, le liquide de la barbotine introduite initialement, puis à titre complémentaire, dans le moule, est en effet aspiré vers la partie perméable du moule qui lui est la plus proche, si les 2 parties du moule sont équivalentes, ce qui est le cas le plus fréquent.

Le liquide sensiblement à mi-distance entre les deux parties du moule peut donc être aspiré vers l'une ou l'autre de ces parties. Dans ces zones à mi-distance entre les deux parties perméables du moule, formant un front de divergence, la pièce frittée est moins dense, et donc plus fragile.

Cette zone poreuse facilite en outre la corrosion ou la pénétration par le silicium liquide. C'est pourquoi, lors d'un moulage traditionnel en plâtre, on cherche à ajuster les paramètres du procédé pour situer ce front de divergence au centre de la pièce afin de limiter ses effets négatifs.

Selon l'invention, l'utilisation d'un moule ne comportant qu'une seule partie perméable élimine ledit front de divergence et permet d'obtenir une pièce dont la densité est très homogène sur toute l'épaisseur « e » de la paroi.

La figure 5 représente la teneur en Calcium de la paroi 38, depuis la surface intérieure 46 (« Profil de [Ca] côté chemise ») et depuis la surface extérieure 48 (« Profil de [Ca] côté plâtre ») du creuset 40. On constate que la teneur en calcium n'augmente pas à l'approche de la surface intérieure 46.

On explique ce phénomène par l'absence de diffusion ou de transport de matière ou d'ions risquant de contaminer la silice depuis la chemise 30 vers la barbotine contenue dans le moule 10. Avantageusement, la surface intérieure 46, en contact avec le matériau à traiter dans le creuset 40, présente ainsi une très grande pureté.

De plus, le caractère imperméable de la chemise 30 évite le transport par le liquide des impuretés provenant du plâtre. En effet, le mouvement d'évacuation du liquide de la barbotine s'effectue exclusivement de la préforme vers la paroi perméable.

Ainsi, à la surface intérieure 46, la teneur en calcium engendrée par la diffusion des espèces à partir du moule en plâtre est plus de 50 fois inférieure à celle mesurée à la surface en contact avec le plâtre, celle du sodium est plus de 10 fois inférieure.

On peut ainsi préserver la pureté de la poudre de silice amorphe initialement employée pour préparer la barbotine. Cette limitation en impuretés permet de limiter la contamination du bain de silicium lors de l'utilisation du creuset, et donc de favoriser des longues durées de vie pour les porteurs de charges des tranches, en anglais « wafers », coupées dans les lingots de silicium poly-cristallin produits à l'aide du creuset 40.

L'absence de contamination de la surface intérieure 46 du creuset 40 provenant du moule 10 permet de réaliser des pièces en silice présentant, à proximité de la surface intérieure 46, une très haute pureté.

Chaque impureté peut en effet rester à un taux proche de celui de la poudre de silice initiale ; on peut ainsi maintenir un taux que ne permettent pas d'atteindre les procédés classiques de coulage en moule en plâtre, en particulier pour le calcium et les autres éléments présents dans le plâtre.

En revanche, classiquement, la teneur en calcium augmente à l'approche de la surface extérieure 48. Il est donc préférable que la partie imperméable 14 du moule 10 soit la partie en contact avec la surface intérieure 46 du creuset 40.

Avec les moules en plâtre, une couche d'un agent démoulant, par exemple de graphite, doit être disposée entre le moule et la barbotine pour faciliter le démoulage de la préforme.

De préférence, selon l'invention, la chemise 30 est en un matériau non adhérent à la préforme, par exemple en silicone. Selon l'invention, un agent démoulant n'est donc plus requis entre la chemise 30 et la barbotine. Avantageusement, la pureté de la surface intérieure 46 du creuset 40 en est améliorée, toute diffusion d'agent démoulant dans la préforme étant exclue. Avantageusement encore, le procédé de fabrication en est simplifié.

En outre, avec les moules classiques en plâtre, l'agent démoulant se dépose partiellement à la surface de la préforme. Il doit donc être éliminé après démoulage de la préforme, pour qu'un matériau de revêtement puisse être ensuite appliqué à la surface de la pièce.

L'élimination de l'agent démoulant se fait classiquement par combustion lors du frittage.

Le matériau de revêtement peut être utilisé pour créer, après séchage, un revêtement fonctionnel. Dans le cas d'un creuset destiné à la fabrication de silicium poly-cristallin, le revêtement de $Si_3N_4$ est utilisé comme agent démoulant pour le silicium, anti mouillant et barrière de diffusion.

Selon l'invention, aucun agent démoulant n'étant nécessaire entre la barbotine et la chemise 30, une couche du matériau de revêtement peut être avantageusement appliquée immédiatement après l'étape de moulage, par exemple en enduisant la surface intérieure 46 de la préforme ayant été en contact avec la face extérieure 32 de la chemise 30. Avantageusement, la bonne résistance mécanique de la préforme selon l'invention permet d'appliquer le revêtement sans risquer d'endommager la préforme.

Avantageusement, la pièce crue et le revêtement par exemple de précurseur de $Si_3N_4$ sont co-frittés. On réalise ainsi une pièce frittée directement utilisable, par exemple pour la fabrication de lingots de silicium utilisés dans les panneaux solaires. On obtient alors un revêtement présentant une excellente adhérence et une remarquable homogénéité.

Les exemples non limitatifs suivants sont donnés dans le but d'illustrer l'invention.

Dans ces exemples, les mesures rhéologiques sont réalisées selon la méthode décrite plus haut.

Les creusets testés comportaient un fond sensiblement carré de plus de 500 mm de côté, et une paroi latérale sensiblement perpendiculaire au fond d'une hauteur sensiblement constante supérieur à 300 mm, d'une épaisseur de 5 à 20 mm.

La résistance mécanique des pièces crues et des pièces frittées est mesurée en flexion sur des barreaux de dimensions 150 mm * 25 mm * 25 mm coupés des pièces réalisées à l'aide d'une presse Lloyd et d'un montage d'entraxe 125 mm muni d'un capteur de 1000 N ou 10 kN.

Exemple 1

Dans cet exemple, on a employé de la silice amorphe obtenue par fusion de sable puis broyée dans des installations réservées au traitement de la silice amorphe de grande pureté pour obtenir différentes fractions granulométriques. Cette source de silice est particulièrement avantageuse car elle permet d'obtenir des poudres d'une très grande pureté et de grande homogénéité. Les surfaces spécifiques des poudres obtenues varient entre 0,01 et 20 $m^2$/g.

On mélange à sec, dans un malaxeur :

25% en poids de poudre de la fraction granulométrique 200 $\mu$m - 620 $\mu$m,
50% en poids de poudre de la fraction granulométrique 40 $\mu$m - 200 $\mu$m,
17% en poids de poudre de la fraction granulométrique 1 $\mu$m - 40 $\mu$m, et
8% en poids de poudre de la fraction granulométrique 0,1 - 1 $\mu$m.

On introduit de l'eau pour avoir une barbotine contenant plus de 87 % en poids de matière sèche. On maintient l'agitation pour obtenir une viscosité comprise entre 1 et 30 Poises.

On coule cette barbotine dans un moule tel que celui représenté sur la figure 1, le côté de la base carrée du moule étant supérieur à 700 mm.

On laisse ensuite l'eau s'évacuer pendant 24 heures par la partie extérieure 12, en plâtre, du moule.

Le support métallique central 31 est enlevé dès la fin de la prise.

La chemise souple 30 peut être ôtée dès cette étape ou rester en place durant la première partie du séchage.

La chemise souple 4 est ensuite retirée avec ou sans injection d'air selon les tailles et formes des pièces désirées. On enlève ensuite les blocs 12a-12f de la partie extérieure 12 du moule. Il est alors possible de déplacer la préforme pour accomplir la phase finale de séchage et de frittage.

La préforme obtenue a une résistance mécanique supérieure à 3 MPa. Elle est séchée dans une étuve à 90°C pendant 12 heures puis frittée à 1200°C pendant 1 heure. La pièce finale frittée a une résistance mécanique de 20 MPa. Le retrait de la préforme lors du frittage est inférieur à 0,5%.

Exemple 2

Le procédé de fabrication est identique à celui de l'exemple 1 mais la distribution granulométrique est la suivante :

25% en poids de poudre de la fraction granulométrique 200-620 $\mu$m,
50% en poids de poudre de la fraction granulométrique 40 - 200 $\mu$m,
15% en poids de poudre de la fraction granulométrique 1-40 $\mu$m,
10% en poids de poudre de la fraction granulométrique 0,2-1 $\mu$m préparée en voie liquide.

La quantité d'eau est ajustée de manière que la barbotine ait un taux de matière sèche, en poids, supérieur à 87%. Les performances sont identiques à celles de l'exemple 2 montrant la stabilité des propriétés des pièces obtenues par rapport aux modes de broyage appliqués aux poudres incorporées dans le mélange.

Exemple 3

Le procédé de fabrication est identique à celui de l'exemple 1 mais la distribution granulométrique est la suivante :

70 à 30 % en poids de poudre de la fraction granulométrique 40 - 200 $\mu$m
50 à 15 % en poids de poudre de la fraction granulométrique 1-40 $\mu$m
35 à 5 % en poids de poudre de la fraction granulométrique 0,2-1 $\mu$m de surface spécifique comprise entre 1 et 50 $m^2$/g. Cette fraction peut être obtenue par fusion et broyage de silice ou synthétisée par hydrolyse à la flamme de $SiCl_4$.

La quantité d'eau est ajustée de manière que la barbotine ait un taux de matière sèche, en poids, supérieur à 86 %.

Cette barbotine est particulièrement adaptée dans le cas de la technique de coulage sous pression dans lequel l'eau est chassée par pression au travers d'un moule polymère. Deux pièces sont réalisées à partir de cette barbotine, l'une dans un moule selon l'invention, l'autre dans un moule adapté au coulage sous pression. La densité des pièces crues est comprise entre 1,6 et 2 g/cm$^3$.

Après frittage, les pièces présentent une résistance en compression à froid comprise entre 80 et 250 MPa, une résistance en flexion trois points comprise entre 16 MPa et 30 MPa, et une densité comprise entre 1,6 et 2,2 g/cm$^3$.

Exemple 4

On procède comme dans l'exemple 1 jusqu'à l'étape de séchage. On enduit alors la surface intérieure 46 ayant été en contact avec la chemise 30 en silicone, vierge d'agent démoulant, d'une suspension aqueuse d'une poudre de $Si_3N_4$ d'un diamètre moyen égal à 15 $\mu$m. Puis on procède au co-frittage de la préforme et du revêtement de $Si_3N_4$ comme dans l'exemple 1 sous atmosphère oxydante, neutre ou réductrice. On obtient ainsi une pièce couverte d'un revêtement adhérent de $Si_3N_4$.

Exemple 5

La barbotine est préparée comme dans l'exemple 1 mais on utilise un moule classique en plâtre (parties intérieure et extérieure en plâtre) pour le moulage. La paroi de la pièce frittée présente, en coupe transversale, une zone centrale moins dense et poreuse ou « front de divergence », symptomatique de l'aspiration d'eau sur les deux côtés (par la surface intérieure 46 et la surface extérieure 48) de la pièce en cours de moulage.

Exemple 6

On prépare un mélange identique à l'exemple 1 mais la viscosité de la barbotine est supérieure à 30 poises, le temps d'écoulement de la barbotine sous son propre poids à travers un orifice calibré de 23 mm est supérieur à 1 min. Le temps de remplissage du moule devient alors très long et les risques de voir la barbotine se figer ou s'écouler difficilement entre les parties du moule sont grandes. Cela conduit à former des pièces incomplètes, notamment dans les angles où le moule n'a pas pu être correctement alimenté.

Exemple 7

On utilise dans le mélange préparé une poudre de surface spécifique supérieure à 50 m$^2$/g pour constituer la fraction < 1 $\mu$m. Il est alors nécessaire d'introduire une quantité d'eau, en poids, supérieure à 14 % pour réaliser la dispersion de la poudre, en raison de la forte surface spécifique de la fraction de cette poudre < 1$\mu$m et de son fort caractère hydrophile. On procède ensuite comme dans l'exemple 1. La barbotine a une viscosité, avant coulage, suffisante pour assurer le remplissage du moule, mais le temps de prise est trop lent. Les mouvements de la barbotine à l'intérieur du moule nécessaires à l'évacuation de la forte quantité d'eau entraînent la formation de zones hétérogènes, susceptibles de donner naissance à des fissures. De plus, l'usage de poudres à très fortes surfaces spécifiques fragilise la préforme et peut contribuer à l'altérer lors du démoulage.
Ce type de barbotine est par ailleurs peu compatible avec le procédé de coulage sous pression ou de coulage en moule plâtre. Les poudres trop fines sont susceptibles de boucher la porosité des moules (résines ou plâtre) et de défavoriser les opérations de démoulage avec des risques élevés de casse.

Exemple 8

On utilise les mêmes matières premières que dans l'exemple 7 mais on prépare la barbotine en ajoutant une quantité d'eau permettant d'obtenir un mélange contenant 82 % de matières sèches, en poids. La viscosité de la barbotine avant coulage est de 0,2 Poise. On procède ensuite comme dans l'exemple 1.
Il se produit une sédimentation des plus gros grains dans la pièce lors du coulage. Ils tombent par gravité vers la partie basse du moule, donnant ainsi des gradients de densité et donc des retraits de séchage différents. Outre les risques de casse lors du séchage, les propriétés physiques, mécaniques, thermiques de la pièce varient en fonction de la partie étudiée.

Exemple 9

Nous préparons un mélange constitué de :

50% en poids de poudre de la fraction granulométrique 200-620 $\mu$m,
10% en poids de poudre de la fraction granulométrique 40-200 $\mu$m,
30% en poids de poudre de la fraction granulométrique 1-40 $\mu$m,
10% en poids de poudre de la fraction granulométrique <1 $\mu$m.

Il est nécessaire d'introduire 12% d'eau, en poids, pour réaliser la dispersion du mélange. La viscosité de la barbotine est inférieure à 30 Poises mais la barbotine présente un seuil d'écoulement trop important qui l'empêche de couler sous son propre poids. Ce type de barbotine ne permet pas de couler des pièces sans procéder à une forte vibration du moule pour mettre en place la barbotine. Cette technique n'est donc pas adaptée pour le coulage de pièces de grandes dimensions et de faibles épaisseurs en moule plâtre.
Ces exemples permettent de constater qu'il est préférable d'utiliser une barbotine selon l'invention pour mettre en oeuvre le procédé selon l'invention et obtenir des pièces de forte compacité, dont la surface de contact est exempte de contamination, faciles à démouler et offrant des bonnes propriétés mécaniques. Comme cela apparaît clairement à présent, le procédé selon l'invention permet de fabriquer des pièces en silice frittée de grandes dimensions, d'une forme quelconque à faible porosité, et sensiblement sans retrait pendant le séchage de la préforme. Le procédé selon l'invention est en outre plus simple que ceux de la technique antérieure.
Bien entendu, la présente invention n'est pas limitée aux modes de réalisation décrits et représentés fournis à titre d'exemples illustratifs et non limitatifs.

**Revendications**

1. Procédé de fabrication d'une pièce en silice frittée comportant les étapes suivantes :

   a) coulage d'une barbotine à base de poudre de silice amorphe et d'un liquide, dans un moule (10) de fabrication d'une préforme, ledit moule comportant des parties intérieure (14) et extérieure (12) aptes à délimiter une paroi (38) de ladite préforme, une seule desdites parties intérieure (14) et extérieure (12), dite « partie perméable » (12), étant perméable audit liquide, au moins dans une zone délimitant une portion utile de ladite paroi (38), l'autre partie étant appelée « partie imperméable » (14),
   b) évacuation, au moins partielle, dudit liquide, pour obtenir une préforme, ledit liquide étant évacué à travers la seule partie perméable (12) dans au moins ladite zone délimitant une portion utile de ladite paroi (38),
   c) démoulage de ladite préforme pour obtenir une pièce crue,
   d) séchage complémentaire de ladite pièce crue,
   e) frittage de ladite pièce crue,

   **caractérisé en ce que** la granulométrie de ladite poudre suit la loi de Füller-Bolomey, ladite poudre présentant un indice de compacité inférieur à 500.

2. Procédé selon la revendication précédente, **caractérisé en ce que**, préalablement à l'étape e), on dispose un matériau de revêtement sur ladite pièce crue.

3. Procédé selon la revendication précédente, **caractérisé en ce que** ledit matériau de revêtement est un précurseur du nitrure de silicium ($Si_3N_4$).

4. Procédé selon l'une des revendications précédentes, **caractérisé en ce que** ladite partie imperméable (14) comporte une chemise (30) déformable sous l'effet d'une modification des dimensions de ladite préforme pendant sa fabrication, ladite chemise n'adhèrant pas à ladite préforme ou pouvant être décollée de ladite préforme par déformation de ladite chemise (30) lors du démoulage.

5. Procédé selon la revendication précédente, **caractérisé en ce que** ladite partie imperméable (14) comporte un support (31) de ladite chemise (30).

6. Procédé selon l'une quelconque des revendications précédentes, **caractérisé en ce que** ladite poudre comprend un mélange d'au moins deux poudres de silice amorphe.

7. Procédé selon l'une quelconque des revendications précédentes, **caractérisé en ce que** ladite poudre ne comporte que des particules dont la taille est comprise entre 0,1 $\mu$m et 620 $\mu$m.

8. Procédé selon l'une quelconque des revendications précédentes, **caractérisé en ce que** ladite poudre ne comporte que des particules dont la taille est comprise entre 0,2 $\mu$m et 200 $\mu$m.

9. Procédé selon l'une quelconque des revendications précédentes, **caractérisé en ce que** ladite barbotine comporte plus de 85 % de matières sèches.

10. Procédé selon l'une quelconque des revendications précédentes, **caractérisé en ce que** ladite barbotine présente une viscosité comprise entre 1 et 30 Poises au début de l'étape a) de coulage.

11. Procédé selon l'une quelconque des revendications précédentes, **caractérisé en ce que** la fraction sèche de ladite barbotine contient plus de 99,5 % de silice.

12. Procédé selon l'une quelconque des revendications précédentes, **caractérisé en ce que** ladite poudre de silice a une surface spécifique comprise entre 0,01 et 20 $m^2$/g.

13. Procédé selon l'une quelconque des revendications précédentes, **caractérisé en ce que** ledit liquide est de l'eau.

14. Procédé selon l'une quelconque des revendications précédentes, **caractérisé en ce qu'**il comporte une étape de coulage sous pression.

**15.** Pièce crue fabriquée selon les étapes a) à c) d'un procédé selon l'une quelconque des revendications précédentes et ne présentant pas de front de divergence, **caractérisée en ce qu'**elle présente une résistance en flexion trois points comprise entre 2 et 10 MPa.

**16.** Pièce crue selon la revendication précédente, **caractérisée en ce qu'**elle présente une densité supérieure à 1,9 g/cm$^3$.

**17.** Pièce en silice frittée fabriquée selon un procédé selon l'une quelconque des revendications 1 à 14, **caractérisée en ce qu'**elle présente une résistance en flexion trois points comprise entre 16 et 30 MPa.

**18.** Pièce en silice frittée selon la revendication précédente, **caractérisée en ce qu'**elle présente une densité comprise entre 1,6 et 2,2 g/cm$^3$

**19.** Utilisation d'une pièce en silice frittée selon l'une quelconque des revendications 17 et 18, en forme de creuset (40), pour la fabrication de lingots de silicium poly-cristallin.

*Fig. 1*

Fig. 2

Fig. 3

Fig. 4

*Fig. 5*

*Fig. 6*

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2726820 A
- US 2002152768 A
- US 5360773 A
- WO 0117902 A
- DE 10130186